# FASCICULE DE BREVET EUROPEEN

(11) **EP 1 272 435 B1**
(45) Date de publication et mention de la délivrance du brevet: **02.01.2004**
(21) Numéro de dépôt: 01923781.7
(22) Date de dépôt: 10.04.2001
(51) Int. Cl.: C03B 40/04, C30B 11/00

(54) **PAROI POREUSE POUR FORMER UNE COUCHE GAZEUSE DE SUSTENTATION**
PORÖSE WAND ZUM ERZEUGEN EINER GASFÖRMIGEN SCHWEBESCHICHT
POROUS WALL FOR FORMING A LEVITATION GAS FILM

(30) Priorité: 11.04.2000 FR 0004614
(43) Date de publication de la demande: 08.01.2003
(73) Titulaire: COMMISSARIAT A L'ENERGIE ATOMIQUE, 75752 Paris Cédex 15 (FR)
(72) Inventeur: PARAYRE, Claude, F-34400 Lunel (FR); KERNEVEZ, Nelly, F-38700 Corenc (FR); GIBON, Gérard, F-38360 Sassenage (FR)
(74) Mandataire: Ilgart, Jean-Christophe
(86) Numéro de dépôt international: PCT/FR2001/001093
(87) Numéro de publication internationale: WO 2001/077036

(56) Documents cités:
- EP-A- 0 070 760
- EP-A- 0 633 229
- EP-A- 0 780 344
- FR-A- 2 220 481
- FR-A- 2 770 231
- PATENT ABSTRACTS OF JAPAN vol. 13, no. 39, 27 janvier 1989 (1989-01-27) -& JP 63 236718 A (YAMAMURA GLASS CO. LTD.THERS: 01), 3 octobre 1988 (1988-10-03)
- PATENT ABSTRACTS OF JAPAN vol. 1999, no. 9, 30 juillet 1999 (1999-07-30) & JP 11 116252 A (CANON INC.), 27 avril 1999 (1999-04-27)
- PATENT ABSTRACTS OF JAPAN vol. 1999, no. 11, 30 septembre 1999 (1999-09-30) & JP 11 171565 A (CANON INC.), 29 juin 1999 (1999-06-29)
- BANIEL, P. ET AL.: "GAS FILM LEVITATION: A UNIQUE CONTAINERLESS TECHNIQUE FOR THE PREPARATION OF FLUORIDE GLASS RODS" JOURNAL OF NON-CRYSTALLINE SOLIDS, NL, NORTH-HOLLAND PHYSICS PUBLISHING, AMSTERDAM, vol. 161, no. 1, 1 août 1993 (1993-08-01), pages 1-6, XP000496901 ISSN: 0022-3093

## Description

L'invention ressortit à une paroi poreuse destinée à former une couche gazeuse de sustentation.

Les procédés de sustentation par une couche gazeuse formant un coussin sont destinés à maintenir un volume liquide au-dessus d'un plateau ou dans un récipient en évitant des contacts matériels qui pourraient souiller ou corroder les surfaces portantes ou au contraire contaminer le liquide par une réaction chimique. La couche gazeuse est formée en soufflant le gaz dans une chambre située derrière la paroi poreuse pour qu'il traverse les pores de la paroi en conservant une pression dynamique suffisante. Voir par exemple FR2220481 A, JP 63 236 718 A, JP 11 116 252 A.

On cherche d'une part à accroître le volume de liquide soulevé tout en évitant les instabilités ou les irrégularités trop grandes de sustentation. Dans le cas courant et typique où la paroi est en forme de plateau ou de coupelle sur lequel le liquide est posé, on peut expliciter les problèmes rencontrés de la façon suivante. L'augmentation du volume de liquide implique soit un accroissement de sa hauteur, soit un accroissement de sa surface et donc de celle de la paroi. Dans ce dernier cas, la flexion de la paroi produite par la perte de charge du gaz à travers elle s'accroît rapidement, ce qui fait qu'on est limité par la résistance de la paroi, sans qu'il soit possible d'accroître beaucoup son épaisseur car la couche gazeuse serais alors difficile à former à une pression suffisante ; si c'est la hauteur du volume de liquide qui doit être accrue, il faut que la couche gazeuse ait une pression dynamique augmentée en conséquence pour continuer de soutenir le volume, ce qui impose une élévation de la pression du gaz derrière la paroi et de la perte de charge à travers la paroi, et donc, encore, une augmentation des efforts de flexion auxquels la paroi est soumise.

D'autre part, on désire aussi contrôler la forme de la surface inférieure du liquide sustenté en modifiant localement la pression et donc l'épaisseur de la couche gazeuse. Cela est possible en accroissant localement le débit de gaz traversant la paroi, notamment en rendant celle-ci plus perméable. En effet, il faut tenir compte des irrégularités de pression et d'écoulement dans la couche gazeuse, et notamment de ce que le gaz qui traverse la paroi au centre du volume de liquide se disperse plus difficilement et crée localement une pression plus grande qu'à la périphérie du volume liquide. Ce phénomène est accentué avec l'augmentation du débit de gaz, et peut mener à la formation d'une poche de gaz sous le centre du volume du liquide, déformant de plus en plus celui-ci et pouvant même le crever ou le disperser.

L'objet de l'invention est donc de mieux maîtriser la sustentation, afin d'une part, d'accroître les volumes soulevés de liquide, sans avoir à craindre de rupture de la paroi poreuse de diffusion, et d'autre part, de contrôler la forme de la surface inférieure de la masse liquide.

Plusieurs modes de réalisation seront proposés et constitueront autant de solutions possibles, mais ils présentent l'élément commun que la paroi présente au moins une structure de renforcement. Une structure de renforcement comporte des surépaisseurs, ce qui d'une part, accroît sa résistance mécanique et d'autre part, permet de contrôler le débit du gaz. Les réalisations de l'invention se distinguent nettement des solutions usuelles où la paroi poreuse a une épaisseur constante, qu'elle soit plane, concave, cylindrique ou autre. Elles doivent aussi être distinguées de certaines conceptions antérieures où la face supérieure, sur laquelle la couche gazeuse est établie, est concave pour mieux retenir le volume liquide alors que la face inférieure de la paroi est plate puisque la surépaisseur périphérique n'est pas produite à dessein et n'est pas forcément placée où la paroi est le plus fortement sollicitée. Dans l'invention, les renforcements peuvent être distribués sous toute la surface de la paroi.

La structure de renforcement sera située du côté de la paroi qui est opposé à la couche gazeuse. Elle comprendra des nervures de formes et de directions variées.

Certaines de ces nervures pourront être circulaires, ce qui permettra de soulager le centre de la paroi et de diminuer le débit de gaz qui le traverse en isolant des chambres de gaz comportant des pressions différentes : si la pression est plus faible dans la chambre centrale, les sollicitations seront moins importantes et le débit qui la traverse sera plus faible aussi.

De tels procédés appelleront un réglage des différentes pressions dans des réalisations perfectionnées. On préconisera alors que des capillaires traversent la paroi pour permettre de prendre la pression à différents endroits de la couche gazeuse. Il deviendra alors possible de commander les pressions dans la chambre ou chacune des chambres situées sous la paroi. Les capillaires pourront aussi se prêter à un rôle actif si on les relie à un dispositif de variation de pression au lieu d'un dispositif de mesure : si par exemple on détecte une pression trop importante de la couche gazeuse au centre de la paroi et du volume de liquide, il sera possible d'aspirer le gaz en excès à cet endroit au moyen du capillaire.

Une disposition d'ordre différent pour lutter contre les irrégularités de pression de la couche impliquera d'établir des rainures centrifuges du côté de la paroi sur lequel la couche gazeuse se forme, de manière à faciliter l'évacuation du gaz au centre de la couche gazeuse vers la périphérie.

L'invention sera maintenant décrite en liaison aux figures, parmi lesquelles :
- la figure 1 est une représentation schématique d'un dispositif de sustentation conforme à l'art antérieur ;
- la figure 2 illustre la formation d'un volume liquide suspendu au-dessus d'une paroi de sustentation de l'art antérieur ;
- la figure 3 est une autre réalisation de plateau poreux ;
- la figure 4 est un diagramme de pression ;
- la figure 5 est une première réalisation de l'invention ;
- la figure 6 est une deuxième réalisation de l'invention ;
- la figure 7 est un diagramme de pression ;
- la figure 8 est une autre réalisation de l'invention ;
- la figure 9 est une réalisation supplémentaire de l'invention ;
- la figure 10 est une réalisation supplémentaire de l'invention ;
- les figures 11, 12 et 13 représentent une autre réalisation de l'invention ;
- la figure 14 représente un emploi possible des capillaires ; et
- les figures 15 et 16 illustrent deux dispositions possibles de rainures.

Toutes les descriptions se rapportent majoritairement à des parois diffusantes dont la surface supérieure définit un plan. Elles peuvent s'appliquer facilement à d'autres formes supérieures de paroi : cylindrique, sphérique et toutes formes concaves ou convexes, symétriques ou axisymétriques.

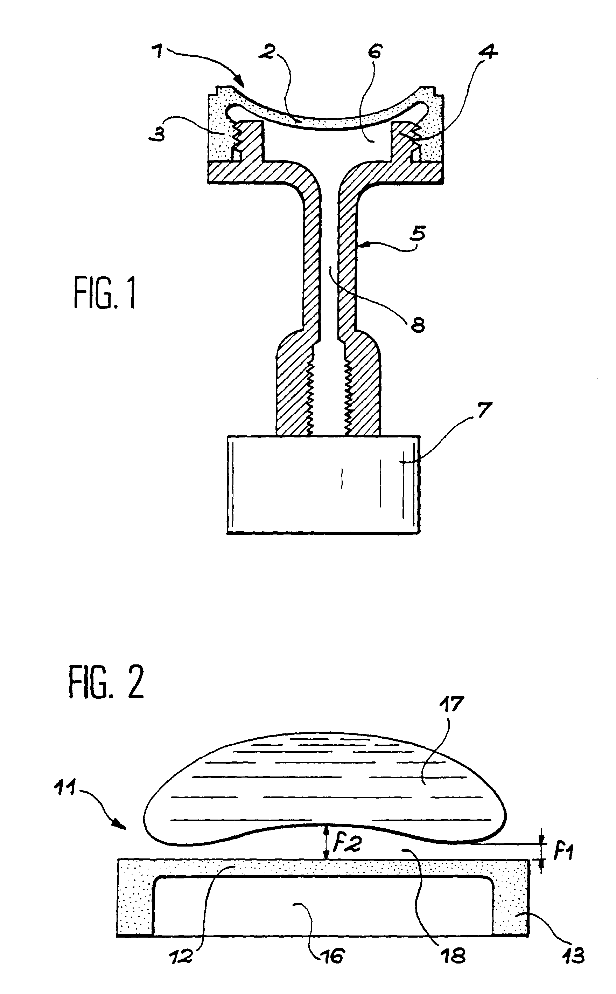

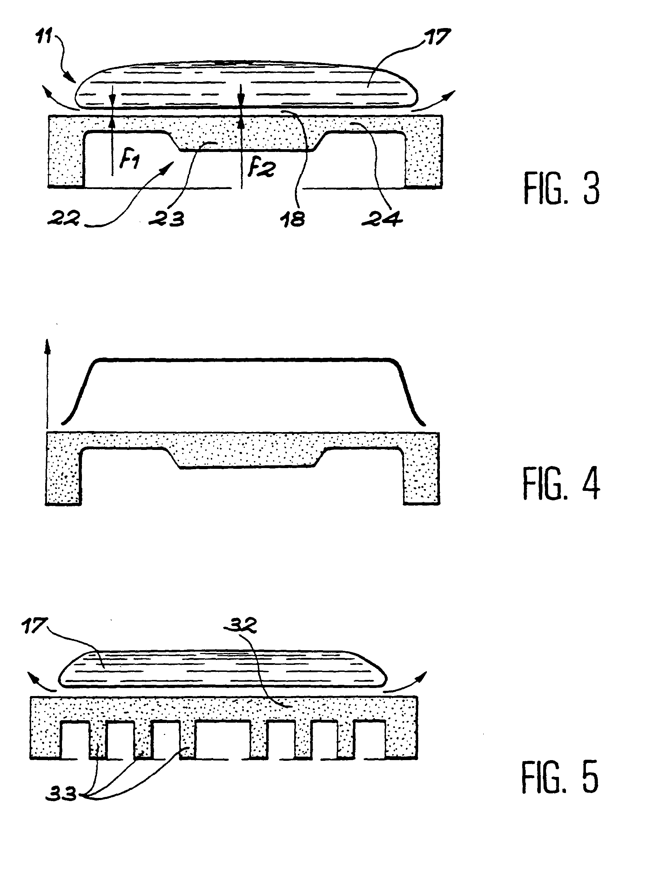

Se reportant à la figure 1, on voit qu'une paroi poreuse 1, conforme à l'art antérieur, comprend un plateau de sustentation 2 d'épaisseur constante à concavité tournée vers le haut et un rebord 3 dirigé vers le bas. Un rebord 4 d'un fût de support 5 est vissé ou serti dans le rebord 3, de manière à isoler une chambre de gaz 6 sous le plateau 2. Une alimentation de gaz 7 injecte du gaz sous pression dans la chambre 6 par un conduit 8 qui traverse le fût de support 5, ce qui établit une couche gazeuse en surpression sur le plateau 2. Cette couche est apte à soutenir un volume de liquide que les forces de capillarité rassemblent en une goutte plus ou moins étalée et déformée. Des variantes de réalisation de la paroi poreuse 1 sont évidemment possibles, et une paroi poreuse de périphérie peut entourer la paroi poreuse 1 pour retenir le liquide. Nous nous reportons cependant à la figure 2 pour d'autres explications. Il y apparaît un plateau 12 (choisi plat pour simplifier l'exposé) d'une paroi poreuse 11 comprenant encore un rebord périphérique inférieur 13 et une chambre de gaz 16 sous le plateau 12, le volume de liquide porte la référence 17 et la couche de gaz intermédiaire, la référence 18. Si, conformément aux conceptions antérieures, l'épaisseur du plateau 12 est constante sur toute sa surface, et la matière poreuse est homogène, le gaz traverse le plateau 12 avec un débit uniforme, ce qui produit une pression plus importante sous le centre du liquide donc un gonflement plutôt défavorable de la couche gazeuse 18 au centre, dont l'épaisseur f2 est sensiblement plus élevée que l'épaisseur f1 de la couche 18 à la périphérie.

On pourrait créer une surépaisseur au centre du plateau 22 de la figure 3 ; la zone centrale épaissie porte la référence 23, et un anneau 24 maintenu à l'épaisseur du plateau 12 subsiste autour d'elle. Le renforcement produit à la fois un soulagement de la zone centrale 23, où les contraintes de flexion seraient plus fortes à épaisseur uniforme du plateau, et une diminution locale du débit du gaz, ce qui uniformise la pression sous la goutte comme le montre selon le schéma de la figure 4, diminuant la différence entre les épaisseurs extrêmes f2 et f1 de la couche gazeuse 18 et le bombement du volume de liquide 17.

Plutôt que par une zone centrale renforcée, on choisit de raidir le plateau par des nervures établies sous celui-ci, de manière qu'ici encore sa face supérieure sur laquelle se forme la couche gazeuse reste lisse. Une première réalisation de l'invention est dessinée à la figure 5, où le plateau porte la référence 32, et les nervures la référence 33. Les nervures 33 contrarient localement la traversée du gaz, ce qui abaisse son débit de sortie du plateau 32 à leur endroit. Si les rainures sont plus nombreuses ou plus larges vers le centre du plateau 32, l'écoulement moyen y sera plus ralenti qu'ailleurs et un effet d'opposition au bombement du volume liquide 17, analogue à celui de la figure 3, sera obtenu.

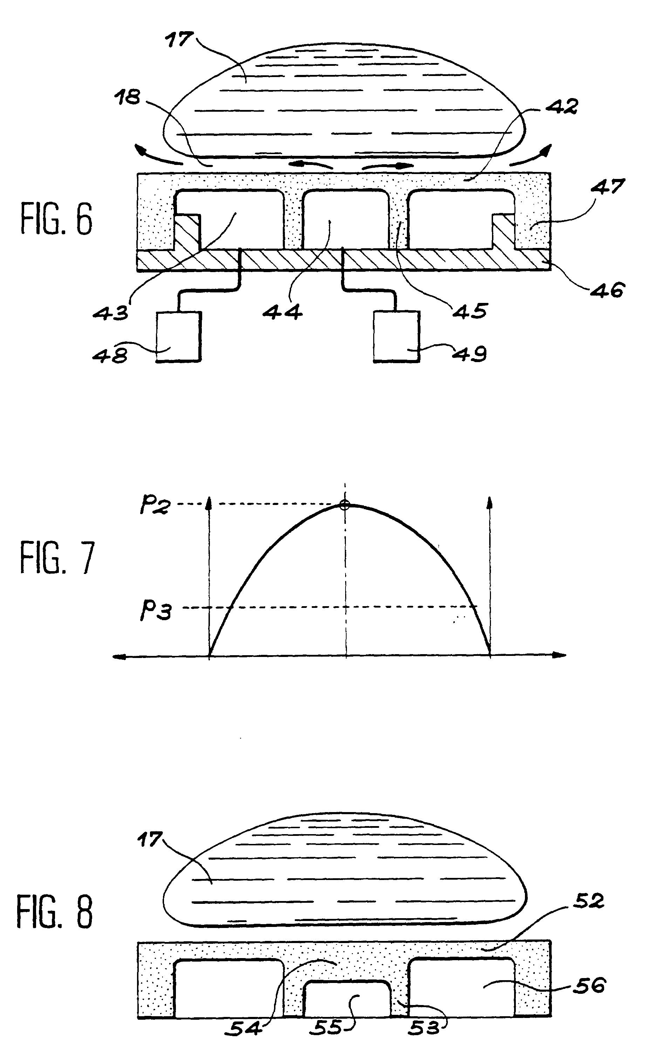

Un autre avantage est procuré par les nervures dans la réalisation de la figure 6. Des nervures continues, notamment circulaires 45, peuvent isoler sous un plateau 42 des chambres de gaz concentriques 43 et 44. Un support 46 complète la séparation des chambres en touchant le bord inférieur de la nervure 45 et en s'étendant jusqu'au rebord 47 du plateau 42. Deux dispositifs d'alimentation en gaz 48 et 49 permettent d'insuffler du gaz respectivement dans les chambres 43 et 44, à des pressions qu'on est libre de choisir. Si ces pressions étaient égales à une pression commune p1, on reviendrait sensiblement à la situation de la figure 2, où une pression p2 règne au centre de la couche gazeuse 18, une pression p3 à la périphérie ; la figure 7 illustre schématiquement le diagramme de pression qu'on pourrait alors mesurer et qui est responsable du bombement central du volume de liquide 17 de la figure 2. Si la pression p1 commune s'accroissait, la différence de pression entre p2 et p3 augmenterait aussi, ainsi que le bombement du volume 17, ce qui produirait finalement une destruction de sa cohésion. Il est au contraire conforme à l'invention que la pression fournie à la chambre centrale 44 soit plus faible que dans la chambre périphérique 43, ce qui égalise l'épaisseur de la couche gazeuse 18 et permet de bénéficier encore d'un aplatissement du volume de liquide 17 au centre.

D'une façon générale, on peut cumuler les dispositions proposées dans les réalisations précédentes ou à venir, ou combiner certains de leurs éléments seulement. La figure 8 représente une telle réalisation composite, où le plateau 52 comprend à la fois une nervure circulaire 53 et une zone centrale à surépaisseur 54 enclose par la nervure 53. La nervure 53 peut ou non servir à séparer deux chambres 55 et 56 concentriques et soumises à des pressions différentes, conformément à l'enseignement de la figure 6 ; cependant, la surépaisseur 54 exerce elle-même une mesure d'égalisation de l'épaisseur de la couche gazeuse 18.

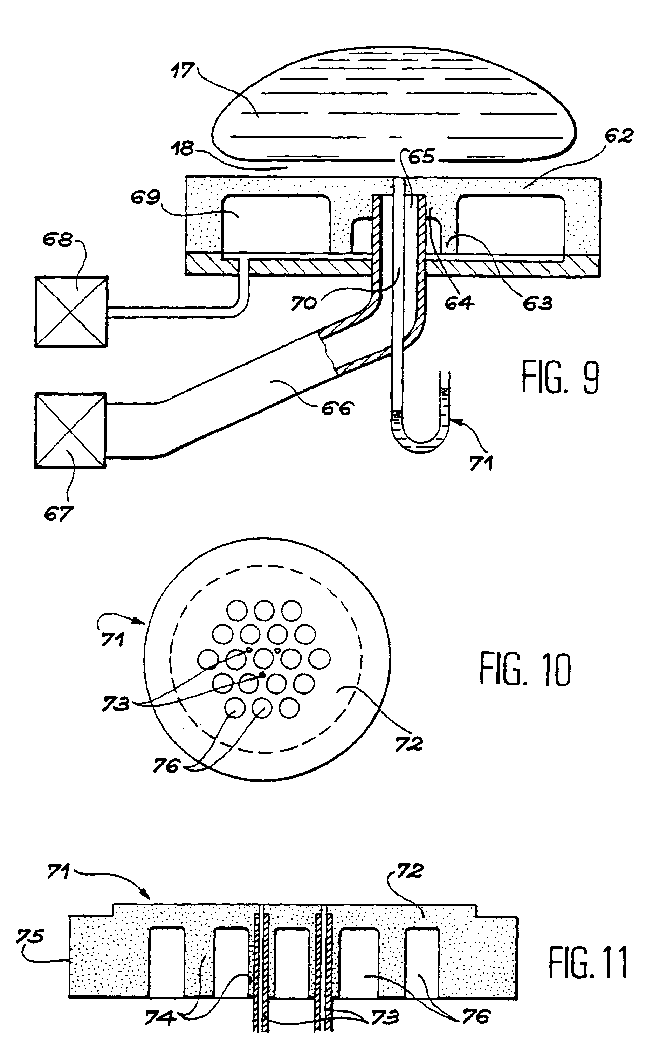

La réalisation de la figure 9 comprend encore, sous un plateau 62, une nervure circulaire 63 et une zone centrale à surépaisseur 64 ; un trou borgne 65 est creusé au centre de la surépaisseur 64 et un conduit 66 y pénètre, qui est relié à une alimentation de gaz particulière 67, différente de l'alimentation en gaz 68 de la chambre 69 entourant le conduit 66 sous le plateau 62. Enfin, un capillaire 70, au'entoure le conduit 66, traverse le plateau 62 et débouche au centre de la couche gazeuse 18 ; il est relié à un dispositif de prise de pression 71. Dans cette réalisation complexe, la pression régnant dans la chambre 69 produit un débit de gaz relativement important à la périphérie de la couche gazeuse 18, et un débit plus faible entre le conduit 66 et la nervure 63, en raison de la surépaisseur 64. Le gaz originaire de l'alimentation 67 du conduit 66 n'a qu'une épaisseur faible à franchir à travers le plateau 62, mais comme sa pression peut être réduite, son débit est également faible. Le capillaire 70 renseigne sur la pression dynamique existant au centre de la couche 18 et permet de régler la pression ou le débit de gaz originaire de l'alimentation 67 à une valeur convenable. On peut ainsi égaliser au mieux l'épaisseur de la couche gazeuse 18.

Cette idée de régler la répartition de la pression dans la couche gazeuse 18 par l'emploi de capillaires de mesure peut être généralisée. Les figures 10, 11 et 12 montrent un trio de capillaires 73 disposés autour du centre d'un plateau 72 ; les nervures 74 n'ont pas ici une forme simple, mais sont les portions restantes de la paroi poreuse 71 comprenant le plateau 72 et rebord 75 périphérique, après qu'on y eut façonné une plaque poreuse de base en y creusant des trous borgnes 76 pour l'amincir. Les capillaires 73 aboutissent à un collecteur 77 englobé par un support 78 de la paroi poreuse 71, et un conduit 79 aboutit dans le collecteur 77. Il peut aboutir soit à un dispositif de prise de pression, soit à un dispositif de réglage de pression 80 qui aspire un peu du gaz du centre de la couche gazeuse 18, pour, ici encore, réduire son épaisseur. Bien entendu, une alimentation 81 injecte du gaz à l'intérieur du support 78 mais hors du collecteur 77 pour former la couche gazeuse 18 de la façon usuelle en traversant le plateau 72.

On peut envisager l'emploi simultané de plusieurs réseaux de capillaires reliés chacun à un dispositif d'aspiration différent, voire à des dispositifs de soufflage, pour parfaire l'égalisation de pression au sein de la couche gazeuse 18 ; de tels réseaux seraient disposés en cercles concentriques et de diamètres différents à travers le plateau. On peut encore disposer toute une série de capillaires analogues à celui de la figure 9 et affectés uniquement à la mesure de la pression à différents rayons de la couche gazeuse 18 indépendamment ou non des réseaux de capillaires de réglage de pression.

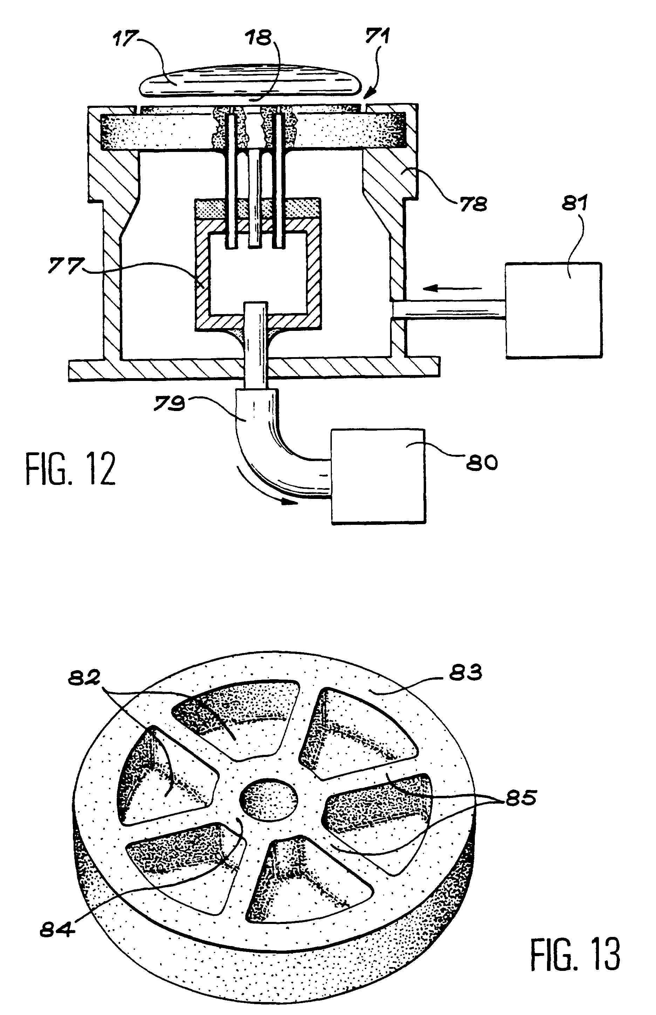

On revient aux nervures pour en donner une forme qui semble particulièrement adaptée à renforcer un plateau 82. La figure 13 illustre que le plateau 82 comprend, dans un rebord 83, une nervure polygonale 84 s'étendant près du centre du plateau 82 et de faible rayon, et des nervures rayonnantes 85 rectilignes joignant le rebord 83 aux angles du polygone. Ici le polygone est un hexagone et les nervures rayonnantes 85 sont au nombre de six. Une nervure circulaire pourrait remplacer la nervure polygonale.

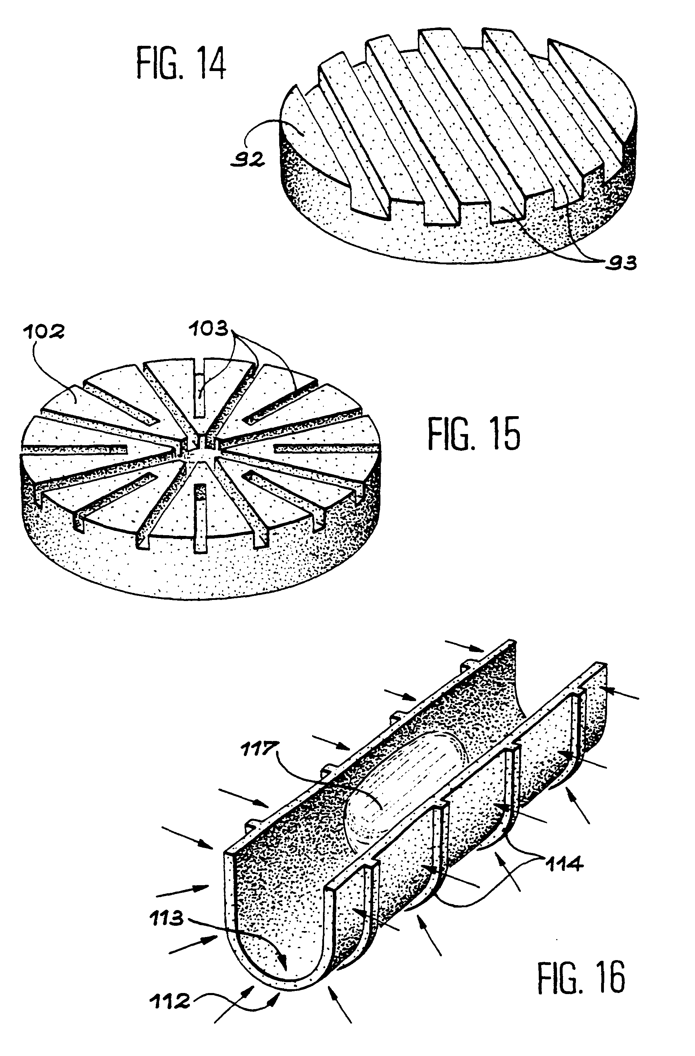

Une disposition d'ordre différent des précédentes peut concourir au même but d'égaliser l'épaisseur de la couche gazeuse 18 : la figure 14 illustre un plateau 92 dont la face supérieure est entaillée de rainures rectilignes et parallèles 93 qui permettent de faciliter la dispersion du gaz de la couche 18 vers sa périphérie ; le même effet est obtenu avec les rainures rayonnantes 103 du plateau 102 de la figure 15.

On doit enfin mentionner que l'invention peut être généralisée à d'autres formes que des plateaux plats et circulaires : la figure 16 illustre ainsi une goulotte 112 dans la concavité 113 de laquelle un volume de liquide 117 se déplace sous l'action de la gravité ; la surpression est ici établie sur la face extérieure de la goulotte 112, conformément à ce que montrent les flèches. L'invention est appliquée en établissant des nervures 114 parallèles en fer à cheval sur la face extérieure de la goulotte 112 ; ces nervures n'ont pas ici pour but d'égaliser l'épaisseur de la couche gazeuse du volume de liquide 117 mais elles renforcent du moins la goulotte 112. D'autres formes de parois poreuses de sustentation, comme les enceintes cylindriques ou autres formes symétriques ou axisymétriques peuvent être renforcées selon l'invention.

Les matériaux utilisés pour réaliser ces parois poreuses doivent être judicieusement choisis afin d'éviter, d'éventuelles interactions chimiques avec le matériau à sustenter en cas de contact ponctuel. Ils sont avantageusement choisis parmi les verres frittés, les métaux poreux (tungstène, graphite, etc.), les céramiques (alumine, carbure de zirconium, nitrure de bore, zircone, thorine, etc.).

## Revendications

1. Paroi poreuse de dispositif de sustentation d'un liquide par une couche gazeuse résultant d'un écoulement de gaz à travers la paroi, **caractérisée en ce qu'**elle présente une structure de renforcement située d'un côté de la paroi qui est opposé à la couche gazeuse et qui comprend des nervures (33, 45, 53, 63, 74, 84, 85, 114).

2. Paroi poreuse selon la revendication 1, la paroi étant circulaire, **caractérisée en ce qu'**au moins une des nervures est rayonnante.

3. Paroi poreuse selon l'une quelconque des revendications 1 ou 2, la paroi étant circulaire, **caractérisée en ce qu'**au moins une des nervures est circulaire.

4. Paroi poreuse selon la revendication 1, **caractérisée en ce que** les nervures sont parallèles.

5. Paroi poreuse selon la revendication 1, **caractérisée en ce que** les nervures sont des portions de séparation de creux (76) usinés dans la paroi.

6. Paroi poreuse selon la revendication 3, **caractérisée en ce que** la nervure circulaire délimite des chambres à des pressions différentes (43, 44) du dispositif.

7. Paroi poreuse selon l'une quelconque des revendications 1 à 6, **caractérisée en ce qu'**elle comprend au moins un capillaire (70, 73) qui la traverse.

8. Paroi poreuse selon la revendication 7, **caractérisée en ce que** le capillaire est relié à une prise de pression (71).

9. Paroi poreuse selon la revendication 7, **caractérisée en ce que** le capillaire est relié à un dispositif de variation de pression (80).

10. Paroi poreuse selon la revendication 9, la paroi étant circulaire, **caractérisée en ce que** le capillaire est au centre de la paroi.

11. Paroi poreuse selon l'une quelconque des revendications 1 à 10, **caractérisée en ce que** la paroi comprend des rainures centrifuges (93, 103) d'un côté de la paroi qui est tourné vers la couche gazeuse.

## Patentansprüche

1. Poröse Wand einer Vorrichtung zur Herstellung des Schwebezustands einer Flüssigkeit durch eine aus einer Gasströmung durch diese Wand resultierende Gasschicht,
**dadurch gekennzeichnet,**
**dass** sie eine Verstärkungsstruktur aufweist, die sich auf einer Seite der Wand befindet, die der Gasschicht entgegengesetzt ist und die Rippen (33, 45, 53, 63, 74, 84, 85, 114) umfasst.

2. Poröse Wand nach Anspruch 1, wobei die Wand kreisförmig ist, **dadurch gekennzeichnet, dass** wenigstens eine der Rippen strahlenförmig ist.

3. Poröse Wand nach einem der Ansprüche 1 oder 2, wobei die Wand kreisförmig ist, **dadurch gekennzeichnet, dass** wenigstens eine der Rippen kreisförmig ist.

4. Poröse Wand nach Anspruch 1, **dadurch gekennzeichnet, dass** die Rippen parallel sind.

5. Poröse Wand nach Anspruch 1, **dadurch gekennzeichnet, dass** die Rippen Trennstücke von in der Wand vorgesehenen Vertiefungen (76) sind.

6. Poröse Wand nach Anspruch 3, **dadurch gekennzeichnet, dass** die kreisförmige Rippe Kammern (43, 44) der Vorrichtung mit unterschiedlichen Drücken abgrenzt.

7. Poröse Wand nach einem der Ansprüche 1 bis 6, **dadurch gekennzeichnet, dass** sie wenigstens eine sie durchquerende Kapillare (70, 73) umfasst.

8. Poröse Wand nach Anspruch 7, **dadurch gekennzeichnet, dass** die Kapillare mit einem Druckanschluss (71) verbunden ist.

9. Poröse Wand nach Anspruch 7, **dadurch gekennzeichnet, dass** die Kapillare mit einer Druckveränderungsvorrichtung (80) verbunden ist.

10. Poröse Wand nach Anspruch 9, wobei die Wand kreisförmig ist, **dadurch gekennzeichnet, dass** die Kapillare sich im Zentrum der Wand befindet.

11. Poröse Wand nach einem der Ansprüche 1 bis 10, **dadurch gekennzeichnet, dass** die Wand auf einer der Gasschicht zugekehrten Seite der Wand zentrifugale Vertiefungen (93, 103) umfasst.

## Claims

1. Porous wall of a device for supporting a liquid by means of a gaseous layer resulting from the flow of a gas through the wall, **characterised in that** it has a strengthening structure on the side of the wall opposite to the gaseous layer containing ribs (33, 45, 53, 63, 74, 84, 85, 114).

2. Porous wall in accordance with claim 1, the wall being circular, **characterised in that** at least one of the ribs is radial.

3. Porous wall in accordance with one of the claims 1 or 2, the wall being circular, **characterised in that** at least one of the ribs is circular.

4. Porous wall in accordance with claim 1, **characterised in that** the ribs are parallel.

5. Porous wall in accordance with claim 1, **characterised in that** the ribs form the separating walls of recesses (76) machined in the wall.

6. Porous wall in accordance with claim 3, **characterised in that** the circular rib forms chambers with different pressures (43, 44) in the device.

7. Porous wall in accordance with any of claims 1 to 6, **characterised in that** it includes at least one capillary (70, 73), that passes through it.

8. Porous wall in accordance with claim 7, **characterised in that** the capillary is connected to a pressure measurement device (71).

9. Porous wall in accordance with claim 7, **characterised in that** the capillary is connected to a pressure regulating device (80).

10. Porous wall in accordance with claim 9, the wall being circular, **characterised in that** the capillary is at the centre of the wall.

11. Porous wall in accordance with any of claims 1 to 10, **characterised in that** the wall includes radial grooves (93, 103) on the side of the wall that is turned towards the gaseous layer.
